# EUROPÄISCHE PATENTANMELDUNG

(11) **EP 2 181 978 A1**
(43) Veröffentlichungstag der Anmeldung: **05.05.2010**
(21) Anmeldenummer: 09170261.3
(22) Anmeldetag: 15.09.2009
(51) Int. Cl.: C04B 41/91, C03C 15/00, H01Q 1/38, H05K 1/03, C03C 17/00

(54) **Keramisches Substratmaterial, Verfahren zur Herstellung und Verwendung desselben sowie Antenne oder Antennenarray**

(30) Priorität: 31.10.2008 DE 102008043352
(71) Anmelder: Micro Systems Engineering GmbH, 95180 Berg (DE)
(72) Erfinder: Schwanke, Dieter, 95030 Hof (DE); Harnack, Mirco, 95180 Berg (DE); Bittner, Achim, 96224 Burgkundstadt (DE); Schmid, Ulrich, 1140 Wien (AT)
(74) Vertreter: Lindner-Vogt, Karin L.

(57) **Zusammenfassung**

Die vorliegende Erfindung betrifft ein keramisches Substratmaterial mit einer ersten Schicht und mindestens einer weiteren, zumindest bereichsweise auf der ersten Schicht angeordneten zweiten Schicht, wobei die erste Schicht aus mindestens einer ersten Komponente aus einem kristallinen Keramikmaterial und/oder einem Glasmaterial als Matrix besteht, wobei die erste Schicht eine zweite Komponente aus einem weiteren kristallinen Keramikmaterial enthält, wobei Mantelbereiche der Kristalle und/oder Kristallagglomerate der zweiten Komponente mindestens bereichsweise derart herausgeätzt sind, dass eine Hohlraumstruktur, vorzugsweise in Form einer Poren- und/oder Röhrenstruktur vorliegt. Um auf die Hohlraumstruktur Dünnschicht-Strukturen aufbringen zu können, ist die zweite Schicht als Versiegelungsschicht ausgebildet, welche die Oberfläche der ersten Schicht in den Bereichen versiegelt, auf denen sie angeordnet ist.

## Beschreibung

Die Erfindung betrifft ein keramisches Substratmaterial mit einer ersten Schicht und ggf. einer weiteren, zumindest bereichsweise auf der ersten Schicht angeordneten zweiten Schicht, wobei die erste Schicht aus mindestens einer ersten Komponente aus einem kristallinen Keramikmaterial und/oder einem Glasmaterial als Matrix besteht und wobei die erste Schicht eine zweite Komponente aus einem weiteren kristallinen Keramikmaterial enthält, wobei Mantelbereiche der Kristalle und/oder Kristallagglomerate der zweiten Komponente mindestens bereichsweise derart herausgeätzt sind, dass eine Hohlraumstruktur, vorzugsweise in Form einer Poren- und/oder Röhrenstruktur, vorliegt. Außerdem betrifft die vorliegende Erfindung die Verwendung eines derartigen keramischen Substratmaterials sowie eine Antenne bzw. ein Antennenarray. Die Erfindung betrifft ferner ein Verfahren zur Herstellung eines derartigen keramischen Substratmaterials.

Ein- oder mehrschichtige keramische Substratmaterialien bilden wichtige Ausgangsmaterialien für mikroelektronische Bauteile, insbesondere für die Telekommunikation. Eine Schicht stellt hierbei eine Lage oder ein Film des Substratmaterials mit einer großen Ausdehnung in zwei Raumrichtungen und einer vergleichsweise kleinen Ausdehnung in die dritte, zu den ersten beiden Raumrichtungen senkrecht verlaufenden Richtung des Raumes dar. Typischerweise hat eine gesinterte Schicht eines LTCC-Substrats eine Dicke von 140 µm.

Aus glaskeramischen Materialien werden sowohl Materialien mit niedriger Dielektrizitätskonstante als auch Materialen mit mäßig hoher Dielektrizitätskonstante (εᵣ) bzw. relativer Permittivität (auch als Dielektrizitätszahl oder Permittivitätszahl bezeichnet) gefertigt. Als Glaskeramik wird ein keramisches Material bezeichnet, das zunächst eine Glaszusammensetzung darstellt, die bei nachfolgendem Tempern bei Temperaturen bis zu 1000°C vor der Kristallisation zu einer dichten Masse sintert, so dass ein teilweise oder vollständig kristallines Material entsteht.

Eine wichtige und kostengünstige Technologie zur Herstellung von mikroelektronischen Substraten mit hoher Belegungsdichte ist die sogenannte "Low Temperatur Cofired Ceramics"-Technologie, im Folgenden als LTCC-Technologie bezeichnet. Die LTCC-Technologie ist eine Technologie zur Herstellung von Mehrlagenschaltungen auf der Basis von gesinterten Keramikträgern. Es können auf den Substraten Leiterbahnen, Kondensatoren, Widerstände und Spulen erzeugt werden. Diese Elemente werden durch Siebdruck oder fotochemische Prozesse auf die jeweilige ungebrannte Schicht aufgebracht. Die ungebrannten Keramikfolien werden einzeln strukturiert und anschließend gestapelt und laminiert. Danach wird zur Verfestigung der Struktur ein definiertes Sinterprofil mit einer Spitzentemperatur von ca. 850°C bis 900°C angewendet.

Ein- oder mehrlagige Substrate für elektronische Anordnungen werden häufig mit Materialien versehen, die eine niedrige Dielektrizitätskonstante aufweisen, wenn bei hohen Frequenzen eine hohe Geschwindigkeit der elektronischen Signale durch das Substrat erreicht werden soll. Bei einer niedrigen Dielektrizitätskonstante bzw. Permittivität wird erreicht, dass ein möglichst großer Teil des HF-Signals, bspw. einer Antenne, abgestrahlt wird und wenig Energie ins Material eingekoppelt und somit nutzmindernd verbraucht wird.

Ein keramisches Substratmaterial sowie ein Verfahren zu dessen Herstellung gemäß den Oberbegriffen der unabhängigen Patentansprüche ist aus DE 10 2007 020 888 bekannt.

Der Porosiziervorgang, d.h. der Ätzschritt, in dem die Hohlraumstruktur in der Matrix des bekannten keramischen Substratmaterials erzeugt wird, ermöglicht die Realisierung einer Dielektrizitätskonstante, welche zwischen Luft (ca. 1) und der verbleibenden Glaskeramik bzw. kristallinen Keramik liegt. Hierbei können in den porosizierten Bereichen resultierende Dielektrizitätskonstanten εᵣ, die sich aus der Dielektrizitätskonstante des nach dem Ätzvorgang verbleibenden Materials der geätzten Schicht und der Dielektrizitätskonstante der Hohlraumstruktur zusammensetzt von bis zu 2 erreicht werden. Die Hohlraumstruktur wird vorzugsweise aus einer Poren- und/oder Röhrenstrukur gebildet.

In den geätzten Bereichen beträgt die resultierende Dielektrizitätskonstante εᵣ zwischen etwa 10 und 1, besonders bevorzugt zwischen etwa 5 und 1. Die lokale Reduktion von εᵣ ist vorteilhaft, da für einen Radarsensor, insbesondere im Bereich von 80 GHz, die Antennenelemente auf einem Gebiet mit niedriger Dielektrizitätskonstante aufgebracht werden sollen. Das Verteilnetzwerk soll jedoch in einem Bereich mit hoher Dielektrizitätskonstante angeordnet werden, um Abstrahlungseffekte zu minimieren.

Wie Versuche bestätigen, können auf einer derartigen porösen Oberfläche, welche mit dem bekannten Verfahren hergestellt wurde, mittels konventioneller Dickschichttechnik Metallisierungen aufgebracht werden. Problematisch ist jedoch die Realisierung von metallisierten Strukturen in Dünnschicht- oder Dünnfilmtechnik, welche Strukturen mit einer typischen Dicke im Bereich von 500 nm bis 3 µm haben und für Höchstfrequenzanwendungen eine laterale Strukturgenauigkeit im Mikrometer-Bereich aufweisen müssen. Insbesondere zeigt sich bei der Realisierung von auf die Poren- und/oder Röhrenstruktur aufgebrachten Dünnschichtstrukturen als hinderlich, dass die Hohlräume der Hohlraumstruktur laterale Dimensionen bis in eine Größenordnung von mehreren Mikrometern aufweisen. Großvolumige Hohlraumstrukturen, d.h. Strukturen, bei denen jeder einzelne Hohlraum eine vergleichsweise große Ausdehnung aufweist, entstehen insbesondere bei langen Ätzzeiten, welche notwendig sind, um eine große Porosiziertiefe und einen hohen Porositätsgrad zu erzeugen. Diese Oberflächenstrukturen verursachen Unebenheiten in darauf aufgetragene Dünnschicht-Leiterbahnen verbunden mit hierdurch verursachten erhöhten spezifischen Widerständen. Die Unebenheiten können im schlechtesten Fall auch zum kompletten Ausfall der Funktion der Dünnschichtstruktur führen.

Ferner besteht das Problem, dass bei einer Verwendung von nasschemischen Ätzverfahren für die Herstellung der Dünnschicht-Leiterbahnen diese unter Umständen von unten angeätzt werden, da in die Röhrenstrukturen/Poren Ätzflüssigkeit eindringt, insbesondere dann, wenn die Poren und/oder Röhren der Hohlraumstruktur eine bestimmte Größe überschreiten. Das Anätzen der Dünnschicht-Struktur kann ein unerwünschtes Ablösen der gesamten Metallisierungsschicht verursachen.

Es ist daher Aufgabe der vorliegenden Erfindung, ein einfaches und kostengünstiges sowie sicheres Verfahren zur Herstellung eines keramischen Substratmaterials anzugeben, das die Anordnung von Dünnschicht-Strukturen auf den porösen Bereichen ermöglicht. Die Aufgabe besteht ferner darin, ein entsprechendes keramisches Substratmaterial zu schaffen, das den Einsatz der LTCC-Technologie und die Realisierung von Bauelementen für Höchstfrequenzanwendungen beziehungsweise weitere Anwendungen, die Dünnschicht-Strukturen erfordern, ermöglicht. Die Aufgabe besteht zudem darin, eine geeignete Verwendung eines derartigen keramischen Substratmaterials anzugeben. Außerdem besteht die Aufgabe darin, eine Antenne oder ein Antennenarray mit einem dicken Substratmaterial zu schaffen, welche einfach und kostengünstig herstellbar sind.

Die obige Aufgabe wird durch ein keramisches Substratmaterial gelöst, bei dem die zweite Schicht als Versiegelungsschicht ausgebildet ist, welche die Oberfläche der ersten Schicht versiegelt.

Das erfindungsgemäße Substratmaterials weist in den Bereichen, in denen die Versiegelungsschicht vorgesehen ist, eine geglättete Oberfläche auf, so dass Dünnschicht-Strukturen aufgebracht werden können. Die Reduktion der Permittivität des keramischen Substratmaterials bleibt aufgrund der Verwendung einer möglichst dünnen, angepassten Versiegelungsschicht bestehen, da auch die Porosität unter der Versiegelung weitgehend erhalten bleibt. Ein zusätzlicher Vorteil des erfindungsgemäßen Substratmaterials besteht darin, dass keine Feuchtigkeit in die Hohlraumstruktur eindringen kann. Würde Wasser in die Hohlraumstruktur eindringen, so würde die effektive Dielektrizitätskonstante des Substratmaterials deutlich und in unerwünschtem Maße erhöht werden, da die effektive Dielektrizitätskonstante von Wasser (εᵣ von etwa 80) sehr hoch ist. Ferner würde die Dielektrizitätskonstante ihren Wert je nach Feuchtigkeitsgrad verändern, was zu unerwünschten Schwankungen z.B. in der Abstrahlcharakteristik des Radarsensors führen würde.

In einem besonders bevorzugten Ausführungsbeispiel des erfindungsgemäßen Substratmaterials weist die Versiegelungsschicht eine Schichtdicke von mindestens etwa 800 nm, vorzugsweise von mindestens etwa 5 µm auf. Durch die geringe Schichtdicke der Versiegelungsschicht wird nur eine geringe Veränderung der Dielektrizitätskonstante des gesamten Substratmaterials bewirkt.

Weiterhin bevorzugt ist, wenn die Versiegelungsschicht ein organisches Material, vorzugsweise Polyimid, und/oder ein keramisches Material und/oder ein Glasmaterial aufweist. Polyimide haben eine geringe Dielektrizitätskonstante und sind photostrukturierbar. Somit ist es möglich, relativ einfach mit gängigen Verfahren der Mikrotechnik Durchkontaktierungen derart zu realisieren, dass Strukturen in Dünnschichttechnik, die auf der organischen Schicht angeordnet sind, elektrisch mit der Unterseite verbunden werden können. Nachteilig ist jedoch die geringe Resistenz gegenüber der Aufnahme von Feuchtigkeit. Die ebenfalls bevorzugt verwendbaren Gläser hingegen nehmen keine Feuchtigkeit auf, sind chemisch- und temperaturresistent und haben in der Regel eine niedrigere Permittivität als oxidische Keramiken. Bei der Verwendung von Siebdruckverfahren können ebenfalls einfach Durchkontaktierungen ausgespart werden, die bereits im keramischen Körper angeordnet sind.

In vorteilhafter Weise wird die Versiegelungsschicht mittels Siebdruck, mittels eines Spin-on-Verfahrens oder mittels eines Sol-Gel-Verfahrens hergestellt. Das sogenannte Spin-on-Verfahren beinhaltet ein Aufschleudern von Materialien wie Gläser oder organische Materialien. Besonders aufgeschleudertes Polyimid zeigt den gewünschten Effekt hinsichtlich der Glättung der Oberfläche der Hohlraumstruktur, so dass auf die Versiegelungsschicht Dünnfilmstrukturen aufgebracht werden können. Mittels eines weiteren Verfahrens, nämlich dem Sol-Gel-Verfahren, kann die Versiegelungsschicht ebenfalls auf einfache Weise hergestellt werden. Bei dem Sol-Gel-Verfahren werden in der Regel aus einem Precursor zusammen mit einer definierten Menge an Wasser und ggf. Katalysatoren in einem Lösungsmittel nach einer Hydrolyse und einer Kondensation zunächst Feststoffpartikel von wenigen Nanometern Größe gebildet, welche in dem Dispersionsmittel kolloidal verteilt sind. Diese vernetzen anschließend und kondensieren so zu einem Gel.

Der Vorteil einer mittels Siebdruck aufgebrachten Versiegelungsschicht besteht darin, dass diese so hergestellt werden kann, dass sie lediglich eine Dicke von wenigen Mikrometern aufweist. Neben der Reduzierung der Schichtdicke können auch Vias, die sich möglicherweise im LTCC-Körper befinden, durch den Siebdruckprozess auf einfache Weise ausgespart werden. Ferner erlaubt die gute Oberflächenqualität des mittels Siebdruck aufgebrachten Materials, vorzugsweise eines Glases, die Anwendung von Dünnschichttechnik für darauf aufgebrachte Schichten.

Die zweite Komponente der ersten Schicht enthält bevorzugt Al₂O₃-Kristallite und/oder eine von Al₂O₃ verschiedene aluminiumbasierte kristalline Verbindung und/oder eine aluminiumoxidbasierte kristalline Verbindung, sowie umgebende Mantelbereiche, die als Grenzübergangsschicht Kristalle und/oder Kristallagglomerate der zweiten Komponente enthalten. Die Mantelbereiche mit den aluminium- und aluminiumoxidbasierten Verbindungen der zweiten Komponente lassen sich mit einem phosphorsäurebasierten Ätzmittel einfach ätzen.

Besonders bevorzugt liegt die geätzte Hohlraumstruktur lediglich in einem vorbestimmten Bereich der ersten Schicht vor und reicht bis in eine vorbestimmte Tiefe der ersten Schicht. Dies führt zu einer vorteilhaften lokalen Erniedrigung der Dielektrizitätskonstante und des Verlustfaktors bzw. zu einer lokalen Reduzierung der thermischen Wärmeleitfähigkeit.

Besonders bevorzugt weist das keramische Substratmaterial mindestens eine weitere dritte Schicht auf, wobei die erste Schicht und die dritte Schicht gemeinsam mittels LTCC-Technologie hergestellt sind. Die LTCC-Technologie vereinfacht die Herstellung des keramischen Substratmaterials weiter. Das Verfahren ist zudem kostengünstig.

In einem weiteren Ausführungsbeispiel weist das erfindungsgemäße Substratmaterial auf der Versiegelungsschicht aufgebrachte metallisierte Bereiche (z.B. Leiterbahnen), welche vorzugsweise mittels Dünnschichttechnik hergestellt sind und vorzugsweise durchgängig von dem Bereich mit darunter liegender Hohlraumstruktur in einen Bereich ohne eine solche Hohlraumstruktur verlaufen. Die metallisierten Bereiche sind demzufolge durchgängig von einem porosizierten in einen nicht porosizierten Bereich ausgeführt und können somit in vorteilhafter Weise in einem Bearbeitungsschritt aufgebracht werden.

Die erfindungsgemäße Verwendung eines oben angegebenen keramischen Substratmaterials umfasst die Anwendung für eine Antenne oder ein Antennenarray, insbesondere für hohe Frequenzen im Bereich von 80 GHz.

Bei den herkömmlichen Antennen oder Antennenarrays wird typischerweise ein Rogers-Tape in eine LTCC-Kavität geklebt und die darüber liegende Metallisierung der beiden Bereiche mittels Drahtbonding verbunden.

Erfindungsgemäß wird die obige Aufgabe demgegenüber durch eine Antenne oder ein Antennenarray mit einem oben angegebenen erfindungsgemäßen Substratmaterial gelöst.

In einem bevorzugten Ausführungsbeispiel weist eine erfindungsgemäße Antenne oder ein erfindungsgemäßes Antennenarray in jedem seiner Elemente in der ersten Schicht bereichsweise eine geätzte Hohlraumstruktur auf und die über der Versiegelungsschicht liegende Metallisierung erstreckt sich von dem Bereich mit der geätzten und mit der Versiegelungsschicht versehenen Hohlraumstruktur bis in einen Bereich, in dem keine geätzte Hohlraumstruktur vorliegt. Die Metallisierung kann hierbei als Dickschicht- oder besonders bevorzugt als Dünnfilmmetallisierung ausgeführt sein. Der Vorteil einer derartigen Antenne oder eines derartigen Antennenarrays besteht darin, dass eine Drahtbond-Verbindung zwischen den Metallisierungen nicht mehr notwendig ist und hierdurch die Zuverlässigkeit des Gesamtaufbaus erhöht wird, da eine Kombination von Materialien entfällt und die Anzahl der Bond-Klebestellen reduziert wird. Zudem wird die AVT (AVT = Aufbau- und Verbindungstechnik) vereinfacht, da kein Bondschritt notwendig ist.

Die obige Aufgabe wird ferner durch ein Verfahren zur Herstellung eines keramischen Substratmaterials gelöst, bei dem die zweite Schicht mittels Siebdruck, mittels eines Spin-on-Verfahrens oder mittels eines Sol-Gel-Prozesses hergestellt wird.

Ein derartiges erfindungsgemäßes Verfahren weist die oben im Zusammenhang mit der Erläuterung des erfindungsgemäßen Substratmaterials genannten Vorteile auf.

In einem bevorzugten Ausführungsbeispiel wird eine thixotrope Glaspaste mittels Siebdruck mit Hilfe eines Rakels auf das Substrat aufgedruckt und vorzugsweise anschließend durch Anwendung eines Temperaturprofils (Heizprofil, Temperaturbehandlung) gesintert. Bei einem beispielhaften Siebdruckverfahren wird die Glaspaste mit Hilfe eines Rakels durch ein strukturiertes Sieb aufgedruckt und anschließend ebenfalls bei ca. 550°C gesintert.

In einem weiteren Ausführungsbeispiel wird eine viskose Glas- oder Polyimidpaste mittels Aufschleudern homogen in einer definierten Schichtdicke auf das Substrat aufgebracht wird und vorzugsweise anschließend durch Anwendung eines Temperaturprofils ausgehärtet. Beispielsweise wird die Glaspaste bei dem Spin-on-Verfahren durch Zentrifugalkräfte gleichmäßig über das poröse Substrat verteilt. Bevorzugt sind dabei Drehgeschwindigkeiten von 500 U/min bis 4000 U/min. Anschließend wird das Glas bei ca. 500°C gesintert.

Bevorzugt wird eine Glaspaste mit der Zusammensetzung 30 bis 40% Blei und 3 bis 7% Cadmium in der Glasfritte und 10 bis 15% Terpineol. Diese Glaspaste ist auch unter dem Handelsnamen "DP5137" im Handel erhältlich und wird von DuPont vertrieben.

Als Polyimid-Paste bevorzugt geeignet ist das von Fuji-Film hergestellte "Durimide 7510", welches zumindest aus 50 bis 70% N-methyl-2-pyrrolidonen, 25 bis 40% Polyamidsäureestern, 4 bis 6% Methacrylatmonomeren und 0,8 bis 1,5% eines Organotitan-Komplexes besteht.

Außerdem kann in einem weiteren Ausführungsbeispiel ein viskoses Gel auf das Substrat mittels des Spin-on-Verfahrens aufgebracht und vorzugsweise anschließend mittels eines Temperaturprofils kalziniert (Austreiben von CO₂) werden.

In einem weiteren Ausführungsbeispiel wird mindestens bereichsweise auf der Versiegelungsschicht eine Dünnschicht-Struktur angeordnet, welche beispielsweise aus Gold oder Silber bestehen kann, welche mittels eines Dünnschicht-Verfahrens, vorzugsweise Kathodenzerstäuben, aufgebracht (abgeschieden) und anschließend nass- oder trockenchemisch strukturiert wird.

Es ist von Vorteil, wenn mindestens bereichsweise auf der Versiegelungsschicht eine Dünnschicht-Struktur angeordnet wird, welche mittels gängiger Verfahren, wie PVD oder CVD, auf dem Substrat abgeschieden und anschließend mittels nass- oder trockenchemischer Verfahren unter Verwendung einer Lackmaske strukturiert wird.

In einem bevorzugten Ausführungsbeispiel wird der Ätzschritt, vorzugsweise mittels einer entsprechenden Maske, in einem vorbestimmten Bereich der ersten Schicht und/oder bis zu einer vorbestimmten Tiefe der ersten Schicht durchgeführt, um lediglich in dem vorbestimmten Bereich und/oder bis zu der vorbestimmten Tiefe der ersten Schicht eine Hohlraumstruktur in der ersten Schicht zu erzeugen. Hierdurch wird erreicht, dass eine lokal reduzierte Dielektrizitätskonstante, nämlich im Bereich der Öffnung der Ätzmaske bis in eine vorgegebene Tiefe der ersten Schicht, bzw. ein lokal reduzierter Verlustfaktor oder eine lokale Reduzierung der thermischen Leitfähigkeit vorliegt. Ferner können definiert mechanische Sollbruchstellen eingebracht werden. Hierbei wird die Ätztiefe hauptsächlich durch die Prozessparameter Temperatur, Konzentration des Ätzmediums und die Zeit der Einwirkung des Ätzmediums gesteuert. Beispielsweise kann bei einer Prozesszeit von 6 Stunden durch ein phosphorsäurebasiertes Ätzmittel eine Tiefe der Hohlraumstruktur in der ersten Schicht von 20 Mikrometern erreicht werden.

In einem weiteren bevorzugten Ausführungsbeispiel bilden die Matrix und die zweite Komponente vor dem Ätzschritt ein Glaskeramik-Material. Dieses Material lässt sich gut im Hinblick auf die erforderliche Kristallgröße und -verteilung der zweiten Komponente sowie des Mantelbereichs der Kristalle und Kristallagglomerate in der ersten Schicht und damit die spätere Struktur der eingeätzten Hohlraumstruktur steuern. Das Glaskeramik-Material lässt sich sehr einfach mittels der LTCC-Technologie verarbeiten. Zudem sind die entsprechenden Bänder (Tapes) kommerziell erhältlich.

In einem weiteren Ausführungsbeispiel enthält die zweite Komponente Al₂O₃-Kristallite und/oder eine von Al₂O₃ verschiedene aluminiumbasierte kristalline Verbindung und/oder eine aluminiumoxidbasierte kristalline Verbindung sowie Mantelbereiche, die als Grenzübergangsschicht Kristalle und/oder Kristallagglomerate der zweiten Komponente enthalten. Die Mantelbereiche der angegebenen Bestandteile der zweiten Komponente bzw. die angegebenen Mantelbereiche lassen sich besonders einfach mittels des bevorzugten nasschemischen Ätzverfahrens, vorzugsweise mittels eines phosphorsäurebasierten Ätzmittels ätzen. Das phosphorsäurebasierte Ätzmittel wird auch für andere Ätzschritte, in denen andere Strukturen hergestellt werden, genutzt, sodass die Handhabung dieses Ätzmittels in der Produktion bekannt ist.

In einem besonders bevorzugten Ausführungsbeispiel weist das Substratmaterial mindestens noch eine zusätzliche dritte Schicht auf, wobei die erste Schicht und die dritte Schicht zunächst als LTCC mittels der LTCC-Technologie hergestellt werden und anschließend in der ersten Schicht eine Hohlraumstruktur erzeugt wird. Die Herstellung der beiden LTCC-Schichten beinhaltet dabei, wie eingangs beschrieben, mindestens einen Sinterschritt, so dass das Porosizieren in der gesinterten ersten Schicht erfolgt. Bei diesem Ausführungsbeispiel ist von Vorteil, dass das Substrat zunächst mit der in der keramischen Mehrlagentechnik üblichen Prozessführung mit innen liegenden Komponenten und Vias hergestellt werden kann, die durch den Ätzvorgang nicht beeinträchtigt werden. Damit ist der Bereich der Dielektrizitätskonstante zwischen 3 und 4, der bisher mittels organischer HF-Materialien realisiert wurde, auch für Keramiken erschlossen, die mittels LTCC-Technologie hergestellt werden.

Weitere Ziele, Merkmale, Vorteile und Anwendungsmöglichkeiten der Erfindung ergeben sich aus der nachfolgenden Beschreibung eines Ausführungsbeispiels eines erfindungsgemäßen keramischen Substratmaterials anhand eines in Figur 1 angegebenen Diagramms sowie einer schematischen Querschnittdarstellung in Figur 2. Ferner wird der Aufbau einer erfindungsgemäßen Antenne anhand einer schematischen Schnittzeichnung in Figur 3 dargestellt. Alle beschriebenen und/oder bildlich dargestellten Merkmale bilden für sich oder in beliebiger Kombination den Gegenstand der vorliegenden Erfindung, unabhängig von ihrer Zusammenfassung in den einzelnen Ansprüchen oder deren Rückbeziehung

### Beispiele

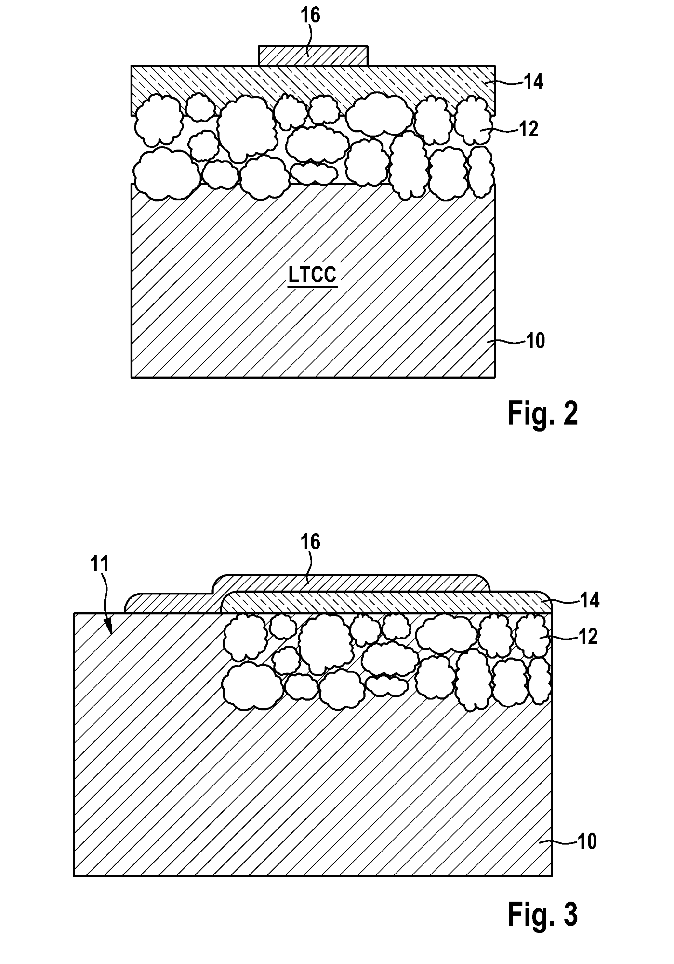

Ein in Figur 2 im Schnitt dargestelltes Substratmaterial mit einer ersten Schicht 10 aus einer gesinterten Glaskeramik, z.B. ein LTCC-Tape mit der Zusammensetzung 30% SiO₂, 40% Al₂O₃, 4% CaO, 9% PbO, 2% B₂O₃ + Rest - Produktbezeichnung DP951, oder mit der Zusammensetzung 30% SiO₂, 20% Al₂O₃, 3% CaO, 5% SrO, 17% BaO, 5% ZnO + Rest - bekannt als "Heraeus-Tape", oder mit der Zusammensetzung ca. 50% Al₂O₃, ca. 15% B₂O₃, ca. 15% La₂O₃ + Rest - Produktbezeichnung DP943 der Fa. Hereaus wird zum Porosizieren bei einer Temperatur von 110°C in eine geeignete Ätzlösung (z.B. für DP951, Hereaus-Tape und DP943 Phosphorsäure) gelegt. Der Porosiziervorgang kann alternativ auch mit KOH (Kalilauge) einer Konzentration von etwa 40% bei einer Temperatur im Bereich von 80°C durchgeführt werden.

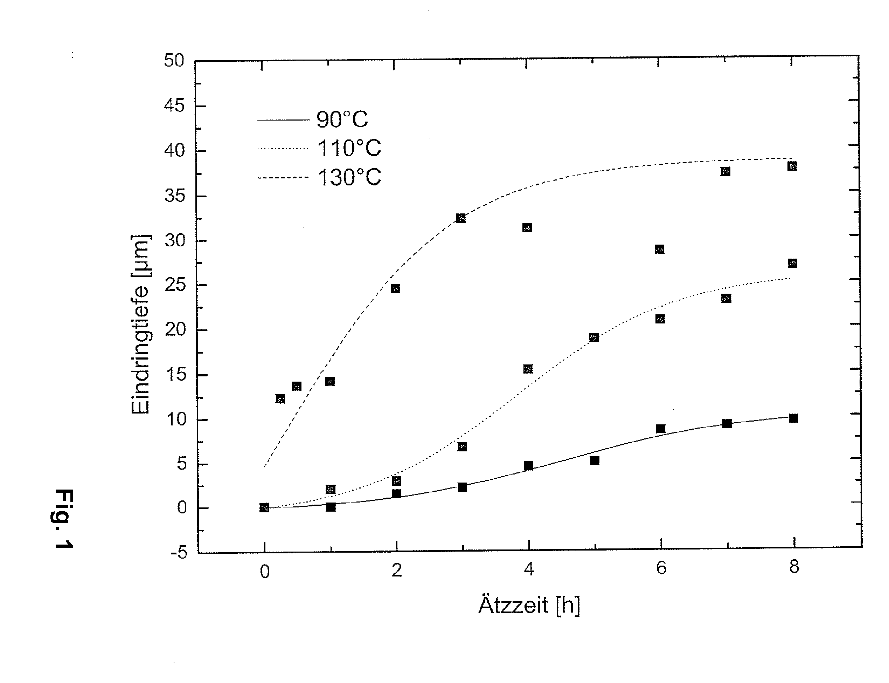

Die in dem Diagramm der Figur 1 dargestellte Kurve zeigt die Abhängigkeit der Eindringtiefe der Ätzlösung Phosphorsäure in DP951 bei einer Ätztemperatur von 130°C (gestrichelte Linie), 110°C (gepunktete Linie) sowie 90°C (durchgezogene Linie) und damit die Tiefe der in der ersten Schicht erzeugten Hohlraumstruktur in Mikrometern auf der Y-Achse von der auf der X-Achse aufgetragenen Ätzzeit in Stunden, da die Eindringtiefe durch die Ätzzeit gesteuert werden kann. Beispielsweise wird bei einer Ätztemperatur von 110°C eine Eindringtiefe von etwa 15 Mikrometern bei einer Ätzzeit von vier Stunden erreicht. Durch den beschriebenen Porosizierschritt wird in dem Substratmaterial eine Poren- und/oder Röhrenstruktur 12 erzeugt.

Nach dem Porosizieren wird mittels Siebdruck, mittels eines Spin-on-Verfahrens oder mittels eines Sol-Gel-Prozesses auf die porosizierten Bereiche mindestens teilweise eine Versiegelungsschicht 14 aufgebracht, welche die porosizierten Bereiche versiegelt, so dass eine Dünnschichtstruktur 16 aufgetragen werden kann.

Als Versiegelung wird bevorzugt eine Glaspaste zumindest bestehend aus 30 bis 40% Blei und 3 bis 7% Cadmium in der Glasfritte und 10 bis 15% Terpineol. Eine solche Glaspaste ist auch unter dem Handelsnamen "DP5137" im Handel erhältlich und wird von DuPont vertrieben.

Alternativ kann als Versiegelung eine Polyimid-Paste verwendet werden. Bevorzugt ist das von Fuji-Film hergestellte "Durimide 7510", welches zumindest aus 50 bis 70% N-methyl-2-pyrrolidonen, 25 bis 40% Polyamidsäureestern, 4 bis 6% Methacrylatmonomeren und 0,8 bis 1,5% eines Organotitan-Komplexes besteht.

Außerdem kann in einem weiteren Ausführungsbeispiel ein viskoses Gel auf das Substrat mittels des Spin-on-Verfahrens aufgebracht und vorzugsweise anschließend mittels eines Temperaturprofils kalziniert (Austreiben von CO₂) werden.

In Figur 3 ist der Aufbau einer erfindungsgemäßen Antenne im Schnitt dargestellt. In einer ersten Schicht 10 ist ein porosizierter Bereich 12 mit der geätzten Hohlraumstruktur vorgesehen, der eine niedrige Dielektrizitätskonstante aufweist. Der porosizierte Bereich 12 geht nahtlos in die übrigen, nicht porosizierten Bereiche 11 der ersten Schicht 10 über. Auf der Oberfläche ist eine Versiegelungsschicht 14 sowie eine metallisierte Schicht (Metallisierung) 16 angeordnet, wobei die Metallisierung 16 oberhalb des porosizierten Bereichs 12 als Antennenstruktur ausgebildet ist. Oberhalb der übrigen Bereiche der ersten Schicht stellt die metallisierte Schicht eine Leiterbahn dar. Die Metallisierung 16 mit der Antennenstruktur und der Leiterbahn kann gleichzeitig in einem Metallisierungsschritt ohne zusätzliche Bondverbindung aufgebracht werden.

### Bezugszeichenliste:

- 10: erste Schicht
- 12: porosizierter Bereich, Hohlraumstruktur
- 14: Versiegelungsschicht
- 16: Dünnfilm-Struktur

## Patentansprüche

1. Keramisches Substratmaterial mit einer ersten Schicht und mindestens einer weiteren, zumindest bereichsweise auf der ersten Schicht angeordneten zweiten Schicht, wobei die erste Schicht aus mindestens einer ersten Komponente aus einem kristallinen Keramikmaterial und/oder einem Glasmaterial als Matrix besteht, wobei die erste Schicht eine zweite Komponente aus einem weiteren kristallinen Keramikmaterial enthält, wobei Mantelbereiche der Kristalle und/oder Kristallagglomerate der zweiten Komponente mindestens bereichsweise derart herausgeätzt sind, dass eine Hohlraumstruktur, vorzugsweise in Form einer Poren- und/oder Röhrenstruktur, vorliegt, **dadurch gekennzeichnet, dass** die zweite Schicht als Versiegelungsschicht ausgebildet ist, welche die Oberfläche der ersten Schicht versiegelt.

2. Keramisches Substratmaterial nach Anspruch 1, **dadurch gekennzeichnet, dass** die Versiegelungsschicht eine Schichtdicke von mindestens etwa 800 nm, vorzugsweise mindestens etwa 5 µm aufweist.

3. Keramisches Substratmaterial nach einem der vorhergehenden Ansprüche, **dadurch gekennzeichnet, dass** die Versiegelungsschicht ein organisches Material und/oder ein keramisches Material und/oder ein Glasmaterial aufweist, vorzugsweise Polyimid.

4. Keramisches Substratmaterial nach einem der vorhergehenden Ansprüche, **dadurch gekennzeichnet, dass** die Versiegelungsschicht mittels Siebdruck, mittels eines Spin-on-Verfahrens oder mittels eines Sol-Gel-Verfahrens hergestellt ist.

5. Keramisches Substratmaterial nach einem der vorhergehenden Ansprüche, **dadurch gekennzeichnet, dass** die geätzte Hohlraumstruktur lediglich in einem vorbestimmten Bereich der ersten Schicht vorliegt und bis in eine vorbestimmte Tiefe der ersten Schicht reicht.

6. Keramisches Substratmaterial nach einem der vorhergehenden Ansprüche, **dadurch gekennzeichnet, dass** die erste Schicht gegebenenfalls zusammen mit einer dritten Schicht mittels LTCC-Technologie hergestellt ist.

7. Keramisches Substratmaterial nach einem der vorhergehenden Ansprüche, **dadurch gekennzeichnet, dass** auf der Versiegelungsschicht metallisierte Bereiche vorliegen, welche vorzugsweise mittels Dünnschichttechnik hergestellt sind und vorzugsweise durchgängig von einem Bereich mit Hohlraumstruktur bis in einen Bereich ohne Hohlraumstruktur verlaufen.

8. Antenne oder Antennenarray mit einem keramischen Substratmaterial nach einem der Ansprüche 1 bis 7.

9. Antenne oder Antennenarray nach Anspruch 8, **dadurch gekennzeichnet, dass** die ersten Schicht die geätzte Hohlraumstruktur bereichsweise aufweist, die Versiegelungsschicht mindestens bereichsweise auf der ersten Schicht mit der geätzten Hohlraumstruktur angeordnet und eine auf der Versiegelungsschicht angeordnete Dünnschicht-Struktur vorgesehen ist.

10. Verfahren zur Herstellung eines keramischen Substratmaterials mit einer ersten Schicht mit einer Hohlraumstruktur und mindestens einer weiteren, zumindest bereichsweise auf der ersten Schicht angeordneten zweiten Schicht, wobei die erste Schicht aus mindestens einer ersten Komponente aus einem kristallinen Keramikmaterial und/oder einem Glasmaterial als Matrix und einer zweiten Komponente aus einem weiteren kristallinen Keramikmaterial besteht, die in der Matrix vorliegt, wobei zur Erzeugung einer Hohlraumstruktur in der ersten Schicht ein vorzugsweise nasschemischer Ätzschritt derart durchgeführt wird, dass in der ersten Schicht selektiv Mantelbereiche der Kristalle und/oder Kristallagglomerate der zweiten Komponente geätzt werden, **dadurch gekennzeichnet, dass** die zweite Schicht als Versiegelungsschicht mittels Siebdruck, mittels eines Spin-on-Verfahrens oder mittels eines Sol-Gel-Prozesses hergestellt wird.

11. Verfahren nach Anspruch 10, **dadurch gekennzeichnet, dass** eine thixotrope Glaspaste mittels Siebdruck mit Hilfe eines Rakels auf das Substrat aufgedruckt und vorzugsweise anschließend gesintert wird.

12. Verfahren nach Anspruch 10, **dadurch gekennzeichnet, dass** eine viskose Glas-oder Polyimidpaste mittels Aufschleudern homogen in einer definierten Schichtdicke auf das Substrat aufgebracht wird und vorzugsweise anschließend ausgehärtet wird oder dass ein viskoses Gel auf das Substrat mittels des Spin-on-Verfahrens aufgebracht wird und vorzugsweise anschließend kalziniert wird.

13. Verfahren nach einem der Ansprüche 10 bis 12, **dadurch gekennzeichnet, dass** mindestens bereichsweise auf der Versiegelungsschicht eine Dünnschicht-Struktur angeordnet wird, welche eines Dünnschicht-Verfahrens, vorzugsweise Kathodenzerstäuben, aufgebracht und anschließend nass- oder trockenchemisch strukturiert wird.

14. Verfahren nach einem der Ansprüche 10 bis 13, **dadurch gekennzeichnet, dass** der Ätzschritt, vorzugsweise mittels einer entsprechenden Maske, in einem vorbestimmten Bereich der ersten Schicht und/oder bis zu einer vorbestimmten Tiefe der ersten Schicht erfolgt, um lediglich in dem vorbestimmten Bereich und/oder bis zu der vorbestimmten Tiefe der ersten Schicht eine Hohlraumstruktur in der ersten Schicht zu erzeugen.

15. Verfahren nach einem der Ansprüche 10 bis 14, **dadurch gekennzeichnet, dass** in dem Mantelbereich der Kristalle und/oder Kristallagglomerate der zweiten Komponente eine Übergangs- oder Zwischenphase der zweiten Komponente geätzt wird, dass die Matrix und die zweite Komponente vor dem Ätzschritt ein Glaskeramik-Material bilden und dass das Substratmaterial mindestens drei Schichten aufweist, wobei die erste Schicht auf einer dritten Schicht angeordnet ist, und dass die erste und die dritte Schicht zunächst als LTCC (Low Temperature Cofired Ceramics) hergestellt werden und anschließend in der ersten Schicht eine Hohlraumstruktur erzeugt wird, bevor die zweite Schicht als Versiegelungsschicht hergestellt wird.
